# EUROPÄISCHE PATENTSCHRIFT

(11) **EP 0 754 167 B1**
(45) Veröffentlichungstag und Bekanntmachung des Hinweises auf die Patenterteilung: **29.07.1998**
(21) Anmeldenummer: 95915052.5
(22) Anmeldetag: 04.04.1995
(51) Int. Cl.: C02F 1/48, B01D 9/00

(54) **VERFAHREN UND VORRICHTUNG ZUR GEZIELTEN BILDUNG VON KEIMEN ODER KRISTALLEN**
PROCESS AND INSTALLATION FOR THE TARGETED FORMATION OF GERMS OR CRYSTALS
PROCEDE ET INSTALLATION DE FORMATION CIBLEE DE GERMES CRISTALLIN S OU DE CRISTAUX

(30) Priorität: 05.04.1994 AT 698/94
(43) Veröffentlichungstag der Anmeldung: 22.01.1997
(73) Patentinhaber: MAITRON CHEMIEFREIE WASSERBEHANDLUNG G.M.B.H., 6020 Innsbruck (AT)
(72) Erfinder: LEITER, Klaus, A-6176 Völs (AT); WALDER, Gerhard, A-6020 Innsbruck (AT)
(74) Vertreter: Torggler, Paul Norbert
(86) Internationale Anmeldenummer: AT9500067
(87) Internationale Veröffentlichungsnummer: WO9526931

(56) Entgegenhaltungen:
- EP-A- 0 376 835
- WO-A-86/04321
- WO-A-87/04422
- GB-A- 646 882
- US-A- 4 529 488
- US-A- 4 822 473
- JOURNAL OF PHYSICS D. APPLIED PHYSICS, Bd.24, Nr.2, 14. Februar 1991, LETCHWORTH GB Seiten 154 - 164 MANN ET AL 'structural and stereochemical relationships'

## Beschreibung

Die Erfindung betrifft eine Vorrichtung zur gezielten Bildung von Keimen oder Kristallen an der Oberfläche eines mit einer Lösung in Berührung stehenden Dielektrikums, insbesondere an den funktionellen Gruppen eines Polymers mit einer Einrichtung zum Erzeugen eines elektrischen Feldes im Dielektrikum, welche eine im Dielektrikum angeordnete elektrisch leitende Elektrode sowie eine elektrisch leitende Elektrode anderer Polarität umfaßt, wobei das elektrische Feld im Dielektrikum die der Lösung zugewandten Oberfläche erfaßt.

Weiters betrifft die Erfindung ein Verfahren zum Steuern der Keimbildung bzw. des epitaktischen Auf-wachsens von Kristallen aus einer Lösung an einer Oberfläche eines Dielektrikums, insbesondere an den funktionellen Gruppen eines Polymers.

Es ist bereits bekannt, daß auf dielektrischen Oberflächen Kristallkeime gebildet werden oder epitaktische Aufwachsen einer mineralischen Phase stattfindet, wobei die chemischen, morphologischen und stereochemischen Eigenschaften der Oberfläche dieses Aufwachsen beeinflussen. Eine solche Keimbildung findet beispielsweise in der Natur statt, wo Biopolymere das Wachstum von Muschelschalen, Skeletten, Zähnen od. dgl. induzieren und kontrollieren. Diese Biomineralisierung ist bei-spielsweise in dem Artikel "Molecular recognition in biomineralization" von Stephen Mann in Nature Vol. 332, 10.3.1988, Seiten 119 ff oder im Buch "Biomineralization" von S. Mann, J. Webb und R.J.P. Williams, CH-Verlag, 1989, Seiten 35 ff beschrieben.

Technische Anwendungen sind bisher beschränkt geblieben auf speziell hergestellte Makromoleküle, die mit bestimmten funktionellen Oberflächengruppen versehen in der Lage sind, Ausfall- und Ausflockungsreaktionen zu steuern (beispielsweise Tenside, Polyphosphate); dazu müssen diese Verbindungen zumeist direkt der Lösung beigemengt werden - das Steuern der Reaktionen ist jedoch lediglich über die Menge, die man zusetzt oder über Zusatz bestimmter Chemikalien, die bestimmte Umladungen der Polymere bewirken, möglich.

EP-A-376 835 beschreibt eine Vorrichtung, die mit Polymeren beschichtete Elektroden enthält. Die Elektroden tauchen direkt in eine Lösung ein. US-A-4 529 488 beschreibt eine Vorrichtung, die mindestens zwei Elektroden enthält. Die Elektroden sind mit einem Polymer beschichtet und sind in eine Lösung getaucht. US-A-4 822 473 beschreibt eine Vorrichtung, die aus einer polymerbeschichteten Elektrode besteht. Die Vorrichtung wird in einen Flüssigkeitsbehälter eingetaucht.

Aufgabe der Erfindung ist es, eine Vorrichtung und ein Verfahren der eingangs genannten Gattung zu schaffen, auf der Kristallkeime bzw. Kristalle mit definierter Form, Größe, Struktur und Orientierung gezielt gesteuert aufwachsen können.

Erfindungsgemäß wird dies bei einer Vorrichtung der eingangs genannten Gattung dadurch erreicht, daß die Elektrode anderer Polarität im bzw. am Dielektrikum angeordnet ist, wobei sich zwischen der Elektrode und zugehöriger Elektrode anderer Polarität keine Lösung befindet.

Mit dem elektrischen Feld erreicht man eine Polarisierung bzw. eine Verstärkung der bereits vorhandenen Polarisierung des Dielektrikums. Im besonderen erreicht man auch die Ausrichtung von funktionellen Gruppen (beispielsweise Carboxylatgruppe, Carbonylgruppe oder Aminogruppe für die Synthese von CaCO₃, CaPO₄) von der Grenzfläche des Dielektrikums weg in die Lösung hinein. Als Folge kommt es zur Ausbildung einer sogenannten elektrischen Doppelschicht. Üblicherweise tritt eine homogene Keimbildung erst bei Erreichen einer kritischen Übersättigung in der Lösung ein. Eine solche kritische Übersättigung läßt sich lokal in der elektrischen Poppelschicht erreichen, indem man über das Potential an den felderzeugenden Elektroden ein elektrisches Feld hervorruft, das das Verhältnis der Konzentrationen der Ionen in der Lösung innerhalb der Doppelschicht ändert.

Beispielsweise läßt sich mit einer negativ geladenen Elektrode das Verhältnis der Konzentrationen von Ca²⁺ und CO₃²⁻ in der Doppelschicht zugunsten der Ca-Ionen verändern. Das Produkt [Ca²⁺] x [CO₃²⁻], das in der Sättigung (thermodynamischen Gleichgewicht, abhängig von pH-Wert und Temperatur) einen bestimmten Wert hat, wird, wenn man zusätzlich berücksichtigt, daß Ca²⁺-Ionen und CO₃²⁻ eine unterschiedliche Anzahl von Wassermolekülen an sich binden und somit unterschiedlich abgeschirmt werden (solvatisiert), in bestimmten Bereichen der Doppelschicht deutlich überschritten - man erreicht lokal eine Übersättigung und kann damit die homogene Keimbildung auslösen.

Darüberhinaus ist es durch das elektrische Feld möglich, eine spezifische Akkumulation der gelösten Ionen im Nahfeld der funktionellen Gruppen und die spezifische Teilnahme der funktionellen Gruppen an der Keimbildungsreaktion zu steuern. Es kommt somit zu einer über das elektrische Feld beeinflußbaren Keimbildung bzw. zum Kristallwachstum. Beispielsweise beeinflussen verschiedene makromolekulare Verbindungen die Keimbildung von mineralischen Phasen an ihrer Oberfläche durch das Vorhandensein von bestimmten funktionellen Gruppen, wie z. B. die Carboxylatgruppe (-COO⁻), die Carbonylgruppe (-CO), die Sulfonatgruppe (-SO₃⁻), die Sulfatgruppe (-OSO₃⁻), die quartäre Aminogruppe (-NR₃⁺, R=H oder eine organische Gruppe), verschiedene Estergruppen etc. Diese funktionellen Gruppen können in unterschiedlicher Weise zur Keimbildung beitragen:
- durch elektrostatische Akkumulation (lokale Übersättigung - homogene Keimbildung)
- durch Ligandenbindung der funktionellen Gruppen zu Kationen aus der Lösung (metallische Ionen) und Erniedrigen der Aktivierungsenergie der Keimbildung (heterogene Keimbildung)
- durch Vorhandensein einer strukturellen und stereochemischen Korrespondenz der funktionellen Gruppen mit einer bestimmten Kristallstruktur wachsen Keime/Kristalle entsprechend der vorgegebenen kristallografischen Struktur auf den funktionellen Gruppen auf (heterogene Keimbildung)
- durch Kombination der vorherigen Effekte.

Mittels des erfindungsgemäß angelegten elektrischen Feldes läßt sich die Aktivität solcher funktionellen Gruppen, deren Ausrichtung und Lage an der Oberfläche gezielt beeinflussen.

Durch spezielle Wahl der Kettenlängen der Polymere lassen sich die funktionalen Gruppen in bestimmten Abständen zueinander anordnen; dadurch ist es möglich eine stereospezifische Oberflächenstruktur zu schaffen, um Kristallkeime/Kristalle bestimmter Größe, Struktur und kristallografischer Orientierung aufwachsen zu lassen (Feineinstellung der Abstände läßt sich durch ein zusätzliches, anders gerichtetes elektrisches Feld oder auch durch mechanischen Streß erreichen - Dehnen, Komprimieren des Kunststoffs).

Als elektrische Felder eignen sich grundsätzlich Gleich- und Wechselfelder oder auch Überlagerungen davon. Besonders günstig ist es, wenn der Betrag und/oder die Richtung und/oder (bei einem Wechselfeld) die Frequenz steuerbar sind. Damit kann man den Keim bzw. Kristallwachstumsprozeß gezielt beeinflussen. Die typischen bevorzugten Feldstärken liegen typischerweise zwischen 0 V/m und 10⁷ V/m.

Weitere Vorteile und Einzelheiten der Erfindung werden anhand der nachfolgenden Figurenbeschreibung näher erläutert.

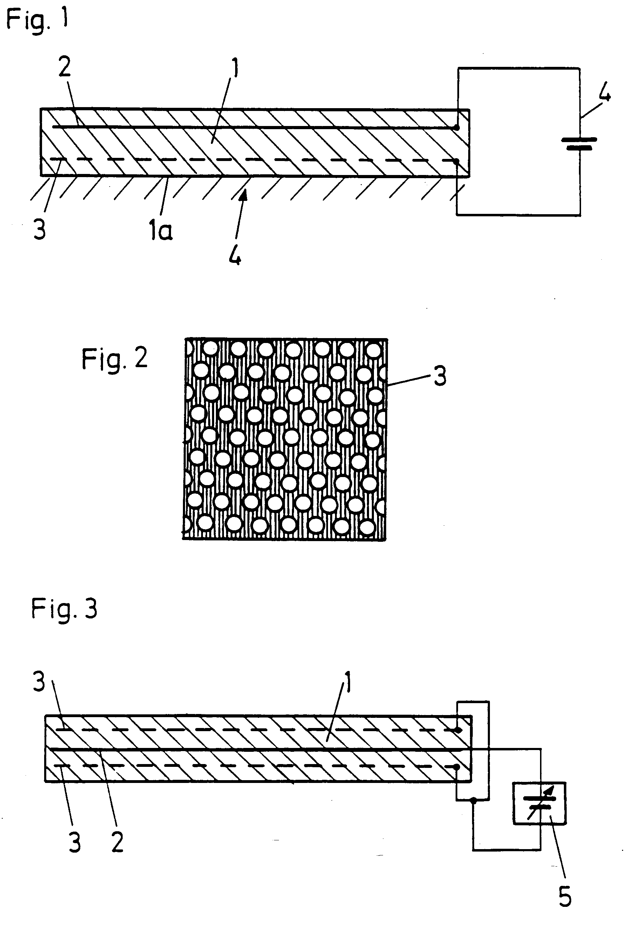

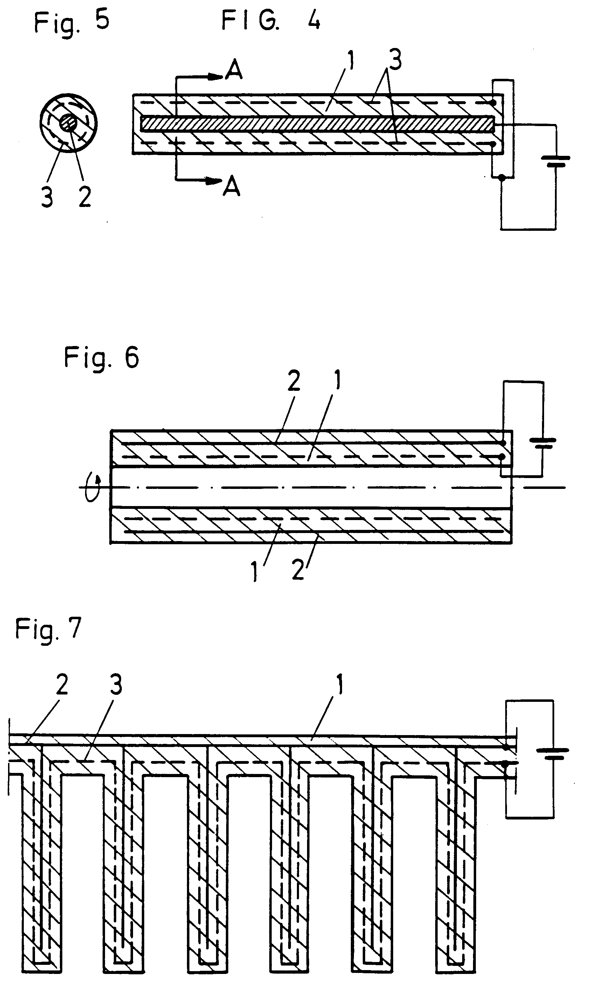

Die Fig. 1 zeigt schematisch ein Ausführungsbeispiel einer erfindungsgemäßen Vorrichtung mit einem Dielektrikum mit ebener Oberfläche. Die Fig. 2 zeigt eine Lochelektrode, wie sie bei der Fig. 1 zum Einsatz kommen kann. Die Fig. 3 zeigt ein weiteres Ausführungsbeispiel, bei dem das Dielektrikum auf beiden Seiten eine zur Keimbildung bzw. Kristallbildung aktive Oberfläche besitzt. Die Fig. 4 Zeigt ein Ausführungsbeispiel mit einer zylindrischen Oberfläche. Die Fig. 5 zeigt einen Schnitt gemäß der Linie A-A der Fig. 4. Die Fig. 6 zeigt ebenfalls eine zylindrische Ausbildung, wobei jedoch die aktive Oberfläche des Dielektrikums, welche dem elektrischen Feld ausgesetzt ist, dem Innenraum eines damit gebildeten Rohres zugewandt ist. Die Fig. 7 zeigt ein Ausführungsbeispiel in Reusenform.

Die in Fig. 1 dargestellte Vorrichtung weist ein Dielektrikum 1, beispielsweise ein Polyamid auf. Im Dielektrikum 1 sind zwei Elektroden 2, 3 eingegossen, die von einer Spannungsquelle 4 mit einer Gleichspannung versorgt werden. Die Elektrode 3 ist als Lochelektrode ausgebildet, wie sie in Fig. 2 gezeigt ist. Damit kommt es durch die Löcher der Lochelektrode 3 zu Felddurchgriffen, die an der aktiven Oberfläche 1a des Dielektrikums zu Polarisierungen führen. Die aktive Oberfläche 1a des Dielektrikums ist der Lösung 4 ausgesetzt, aus der die Keime bzw. Kristalle auf der Oberfläche aufwachsen sollen. Mit der in den Fig. 1, 2 dargestellten Ausführungsform der erfindungsgemäßen Vorrichtung läßt sich beispielsweise eine erhöhte Kalkabscheidung an einer Polyamidoberfläche aus einer bezüglich Kalk übersättigten wässrigen Lösung 4 erzielen.

Polyamide bilden in der Regel unverzweigte Ketten mit wiederkehrenden Carbonsäureamid-Gruppen:

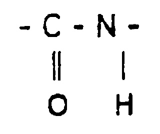

Die Molekülmasse ist zwischen 15000 und 50000. Polyamide sind in erster Linie thermoplastische Kunstoffe.

Als Dielektrikum wird Polyamid 6 verwendet. Die Löcher in der Elektrode 3 sind kreisförmig und haben einen Durchmesser von 5 mm. Die jeweilige Polyamidschicht hat eine Dicke von 1 mm.

Durch Anlegen einer Potentialdifferenz von 0 V bis 1000 V läßt sich der Betrag der maximalen Vertikalkomponente des elektrischen Feldes an der Oberfläche des Dielektrikums von 0 V/m bis ca. 2 x 10⁵ V/m variieren (linear).

Durch Mischen wäßriger Lösungen von CaCl₂ und Na₂CO₃ / NaHCO₃ bei einem pH-Wert von 10 lassen sich übersättigte Lösungen in einem breiten Bereich definieren.

Bei einem Experiment zur Prüfung der Funktionsweise werden zwei identisch aufgebaute Vorrichtungen verwendet. Eine Vorrichtung wird stets ohne Anlegen einer Potentialdifferenz betrieben (Referenz). Die zweite Vorrichtung ist die eigentliche erfindungsgemäß mit einem elektrischen Feld betriebene Vorrichtung.

Vor einer jeden Messung werden vorhandene Kalkschichten auf den Vorrichtungen durch ein Bad in 5%-iger Salzsäure entfernt, anschließend werden die Vorrichtungen mit bidestilliertem Wasser gereinigt, in einem Exsikkator getrocknet und das Trockengewicht mit einer Analysenwaage bestimmt.

Die Vorrichtungen werden in die übersättigte Lösung getaucht, an einer der Vorrichtungen wird eine entsprechende Potentialdifferenz angelegt. Nach einer bestimmten Zeit werden die Vorrichtungen aus der Lösung genommen, im Exsikkator getrocknet und das Trockengewicht mit der Analysenwaage bestimmt. Die Gewichtsdifferenz Trockengewicht nachher minus Trockengewicht vorher bezeichnet den abgelagerten Kalk.

In verschiedenen Versuchsläufen wurde gezeigt, daß in Abhängigkeit von der anliegenden Feldstärke im selben Zeitraum deutlich mehr Kalk auf der Vorrichtung mit elektrischem Feld abgeschieden wird als auf der Vorrichtung (ohne Feld).

Diese Ergebnisse zeigen, daß eine spezifische polarisierte Oberfläche geeignet ist, um die Keimbildung von Kalk zu beschleunigen.

Als Dielektrika eignen sich insbesondere Polymere, Kristalle, Keramiken, Metalloxide oder Gläser. Besonders vorteilhaft sind Polymere, weil diese durch Auswahl geeigneter Monomere auf einfache Weise den Einbau von funktionellen Gruppen als eigentliche Zentren der Kristallkeimbildung erlauben.

Die Elektroden können bei einem aushärtenden Dielektrikum in dieses eingegossen werden, wie dies in Fig. 1 gezeigt ist. Es ist aber auch möglich, die Elektroden zumindest teilweise als leitende Schichten aufzudampfen oder Leitfähigkeitslacke bzw. Amalganschichten zu verwenden. Grundsätzlich sind auch Elektrolyten als Elektroden denkbar und möglich.

Das Dielektrikum und/oder die das elektrische Feld erzeugenden Elektroden können mittels Planar-Epitaxie (Reprotechnik, Maskentechnik, Elektronenstrahl-Lithographie) hergestellt werden. Damit ist es möglich, kleinste Strukturen an der Oberfläche auszubilden und damit das Kristall- oder Keimwachstum entsprechend zu beeinflussen. Eine Feinabstimmung ist abgesehen von einer Variierung des erfindungsgemäßen elektrischen Feldes auch durch Mittel zum Dehnen oder Komprimieren des Dielektrikums möglich. Dies kann durch Aufbringen einer entsprechenden Kraft oder aber durch Temperaturerhöhung oder -erniedrigung erzielt werden.

Im allgemeinen ist man auch daran interessiert, das Kristall- bzw. Keimwachstum zu beschränken. Deshalb sieht die Erfindung vorteilhaft vor, daß Mittel zum Ablösen der auf dem Dielektrikum gebildeten Keime oder Kristalle vorgesehen sind. Diese Mittel können einzeln oder zusammen angewandt werden. Eine Möglichkeit besteht darin, über eine Steuereinrichtung das elektrische Feld abzuschalten oder umzupolen. Auch eine Ablösung mittels einer Ultraschallquelle ist möglich. Schließlich kann man auch die Lösung 4 bewegen, also eine Strömung hervorrufen, die durch Scherkräfte entlang der Oberfläche ausreichend große Kristalle mit sich reißt.

Neben der in den Fig. 1 und 2 dargestellten Ausführungsform und der bereits angedeuteten Varianten sind noch weitere Varianten denkbar und möglich. Beispielsweise zeigt die Fig. 3 eine Variante, bei der beidseitig einer mittleren Elektrode Lochelektroden 3 angeordnet sind, durch die Felddurchgriffe des elektrischen Feldes erfolgen. Damit hat die in Fig. 3 gezeigte Vorrichtung zwei aktive ebenen Oberflächen. Über eine Steuereinrichtung 5 läßt sich die Größe des angelegten Potentials und damit die Feldstärke einstellen. Es wäre auch möglich, die obere und untere Lochelektrode 3 auf verschiedene Spannungen zu legen.

Bei der in Fig. 4 dargestellten Ausführungsform handelt es sich um eine Vorrichtung mit einer zylindrischen Außenoberfläche. Die Lochelektrode ist zylindrisch gekrümmt und um eine zentrale mittlere Elektrode 2 herum angeordnet. Die Fig. 5 zeigt einen entsprechenden Querschnitt.

Die Fig. 6 zeigt ein Ausführungsbeispiel, bei der die Vorrichtung insgesamt rohrförmig ausgebildet ist. Eine zylindrische Außenelektrode 2 im Dielektrikum umgibt eine zylindrische Innenelektrode 3, die ebenfalls im Dielektrikum eingebettet ist. Diese Innenelektrode 3 ist als Lochelektrode ausgebildet, sodaß das elektrische Feld die zylindrische Innenfläche des Dielektrikums erreicht.

Die Fig. 7 zeigt ein Ausführungsbeispiel in einer Reusenform.

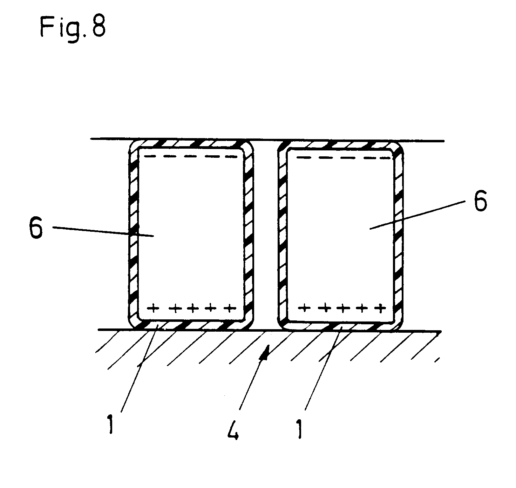

Neben der Hervorrufung eines elektrischen Feldes durch Anlegen eines Potentials an vorzugsweise metallische Elektroden besteht auch die Möglichkeit, das elektrische Feld auf andere Weise zu erzeugen, beispielsweise eignen sich auch der pyroelektrische oder der piezoelektrische Effekt zur Felderzeugung. Eine weitere bevorzugte Ausführungsform ist in Fig. 8 dargestellt. Dort kommen sogenannte Elektrete 6 (das sind Dielektrika mit hohen permanenten elektrischen Dipolmomenten) zum Einsatz, um das Feld zu erzeugen. Viele Elektrete können den Ferroelektrika zugerechnet werden. Beispielsweise lassen sich keramische Werkstoffe aus Bariumtitanat durch Abkühlen von Temperaturen oberhalb ihres Curie-Punktes in einem elektrischen Feld polarisieren. Auch bestimmte Harze, Wachse, Polyurethane, Polyethylen und Fluorkohlenstoffe, die in einem starken elektrischen Feld geschmolzen werden, behalten die dadurch erzwungene Ausrichtung ihrer Dipole bei, wenn nach dem Erstarren das Feld abgeschaltet wird.

Das Elektret 6 ist jeweils durch eine Polymerschicht 1 vor Entladung durch die Flüssigkeit geschützt. Diese Polymerschicht bildet gleichzeitig das der Lösung ausgesetzte Dielektrikum und ist zweckmäßigerweise auch Träger aktiver funktioneller Gruppen, die als Zentren der Keimbildung bzw. Kristallisation fungieren.

Besonders günstig ist ein elektrisches Feld, das eine auf die Oberfläche des Dielektrikums senkrechte Feldkomponente aufweist.

Die Erfindung betrifft weiters ein Verfahren zum Steuern der Keimbildung bzw. des epitaktischen Aufwachsens von Kristallen aus einer Lösung an einer Oberfläche eines Dielektrikums. Beim erfindungsgemäßen Verfahren ist vorgesehen, daß das Dielektrikum im Bereich seiner Oberfläche einem einstellbaren elektrischen Feld ausgesetzt wird. Durch diese Maßnahme können unpolare Moleküle im elektrischen Feld polarisiert werden bzw. bereits polare Moleküle im elektrischen Feld ausgerichtet werden. Insbesondere ist es möglich, funktionelle Gruppen an der Oberfläche des Dielektrikums gesteuert und gezielt von dieser weg in die Lösung hinein auszurichten und damit die Aktivität im Hinblick auf Keimbildung oder Kristallisation zu beeinflussen.

Die Erfindung erlaubt zahlreiche technische Anwendungen, von denen im folgenden nur einige erwähnt seien:

Bildung von Kristallkeimen (Saatkristallen) mittels denen man Ausfäll- und Ausflockungsreaktionen insbesondere zur physikalischen Wasserbehandlung steuern kann (über Konzentration, Form, Struktur und Größe der Keime),
Züchten von Kristallen/Kristallkeimen mit definierter Form, Größe, Struktur und kristallografischen Orientierung,
Umkehrung des Effektes der Keimbildung - durch entsprechende Einstellung der elektrischen Doppelschicht lassen sich Oberflächen erzeugen, an denen sich keine Ablagerungen aus der Lösung bilden - Spezialrohre für speziellen industriellen Einsatz (Industriewässer, Abwässer, Pipelinerohre).

## Patentansprüche

1. Vorrichtung zur gezielten Bildung von Keimen oder Kristallen an der Oberfläche eines mit einer Lösung in Berührung stehenden Dielektrikums, insbesondere an den funktionellen Gruppen eines Polymers mit einer Einrichtung zum Erzeugen eines elektrischen Feldes im Dielektrikum welche eine im Dielektrikum angeordnete elektrisch leitende Elektrode sowie eine elektrisch leitende Elektrode anderer Polarität umfaßt, wobei das elektrische Feld im Dielektrikum (1) die der Lösung zugewandten Oberfläche erfaßt, dadurch gekennzeichnet, daß die Elektrode (3) anderer Polarität im bzw. am Dielektrikum (1) angeordnet ist, wobei sich zwischen der Elektrode (2) und zugehöriger Elektrode (3) anderer Polarität keine Lösung befindet.

2. Vorrichtung nach Anspruch 1, dadurch gekennzeichnet, daß das von der Einrichtung erzeugte elektrische Feld mittels einer Steuereinrichtung (5) verstellbar ist, wobei die Größe des elektrischen Feldes im Bereich der Oberfläche des Dielektrikums (1) einstellbar ist.

3. Vorrichtung nach Anspruch 1 oder 2, dadurch gekennzeichnet, daß das elektrische Feld ein Gleichfeld ist, wobei vorzugsweise Betrag und/oder Richtung des Feldes steuerbar sind.

4. Vorrichtung nach Anspruch 1 oder 2, dadurch gekennzeichnet, daß das elektrische Feld ein Wechselfeld ist, wobei vorzugsweise Betrag, Richtung und/oder die Frequenz steuerbar sind.

5. Vorrichtung nach einem der Ansprüche 1 bis 4, dadurch gekennzeichnet, daß als Dielektrika (1) Polymere, Kristalle, Keramiken, Metalloxide oder Gläser verwendet werden.

6. Vorrichtung nach einem der Ansprüche 1 bis 5, dadurch gekennzeichnet, daß ein dielektrisches Grundmaterial (1) zumindest im Oberflächenbereich funktionelle Gruppen, wie beispielsweise Carboxylatgruppen, Carbonylgruppen oder Aminogruppen, aufweist.

7. Vorrichtung nach Anspruch 6, dadurch gekennzeichnet, daß die funktionellen Gruppen durch Auswahl geeigneter Monomere in eine polymere Matrix eingebaut sind.

8. Vorrichtung nach einem der Ansprüche 1 bis 7, dadurch gekennzeichnet, daß die Oberfläche des Dielektrikums (1) - vorzugsweise zylindrisch - gekrümmt ist.

9. Vorrichtung nach einem der Ansprüche 1 bis 8, dadurch gekennzeichnet, daß die Oberfläche des Dielektrikums (1) die Innenfläche eines Rohres bildet.

10. Vorrichtung nach einem der Ansprüche 1 bis 7, dadurch gekennzeichnet, daß die Oberfläche des Dielektrikums (1) im wesentlichen eben ist.

11. Vorrichtung nach einem der Ansprüche 1 bis 7, dadurch gekennzeichnet, daß die Oberfläche des Dielektrikums (1) Reusenform hat.

12. Vorrichtung nach einem der Ansprüche 1 bis 11, dadurch gekennzeichnet, daß eine Elektrode eine Lochelektrode (3) ist, wobei das elektrische Feld durch die Locher der Lochelektrode (3) durchgreift und die Oberfläche des Dielektrikums (1) erfaßt.

13. Vorrichtung nach Anspruch 12, dadurch gekenn-zeichnet, daß im Dielektrikum (1) beidseits von einer zentralen im wesentlichen ebenen Elektrode (2) im wesentlichen ebene Lochelektroden (3) angeordnet sind.

14. Vorrichtung nach einem der Ansprüche 1 bis 13, dadurch gekennzeichnet, daß die Elektroden (3) zumindest teilweise zylindrisch gekrümmt sind.

15. Vorrichtung nach einem der Ansprüche 1 bis 14, dadurch gekennzeichnet, daß als Elektroden (2, 3) Metallelektroden, Metallgitter, Metallfolien, elektrisch leitfähige Kunststoffe und/oder Graphit verwendet werden.

16. Vorrichtung nach einem der Ansprüche 1 bis 15, dadurch gekennzeichnet, daß die Elektroden (2, 3) zumindest teilweise in ein aushärtendes Dielek-trikum eingegossen werden.

17. Vorrichtung nach einem der Ansprüche 1 bis 16, dadurch gekennzeichnet, daß die Elektroden zumindest teilweise als leitende Schichten aufgedampft oder als Leitfähigkeitslack oder Amalganschichten aufgebracht werden.

18. Vorrichtung nach einem der Ansprüche 1 bis 17, dadurch gekennzeichnet, daß die Elektroden zumindest teilweise als Elektrolyt realisiert werden.

19. Vorrichtung nach einem der Ansprüche 1 bis 18, dadurch gekennzeichnet, daß das elektrische Feld durch mindestens ein Elektret (6) gebildet wird.

20. Vorrichtung nach Anspruch 19, dadurch gekennzeichnet, daß das Elektret (6) von einer vorzugsweise aktiven funktionelle Gruppen tragenden Schicht, insbesondere Polymerschicht (1) umgeben ist.

21. Vorrichtung nach einem der Ansprüche 1 bis 20, dadurch gekennzeichnet, daß das elektrische Feld durch einen pyroelektrische oder einen piezoelektrische Effekt erzeugt wird.

22. Vorrichtung nach einem der Ansprüche 1 bis 21, dadurch gekennzeichnet, daß das Dielektrikum und/oder die das elektrische Feld erzeugenden Elektroden mittels Planar-Epitaxie erzeugt sind.

23. Vorrichtung nach einem der Ansprüche 1 bis 22, dadurch gekennzeichnet, daß das Potential der Lösung auf eine gegen die felderzeugenden Elektroden definiertes höheres, niedrigeres oder gleich hohes Potential gelegt ist.

24. Vorrichtung nach einem der Ansprüche 1 bis 23, gekennzeichnet durch Mittel zum Dehnen oder Komprimieren des Dielektrikums.

25. Vorrichtung nach einem der Ansprüche 1 bis 24, gekennzeichnet durch Mittel zum Ablösen der auf dem Dielektrikum gebildeten Keime oder Kristalle.

26. Vorrichtung nach Anspruch 25, dadurch gekennzeichnet, daß die Mittel eine Steuereinrichtung zum Abschalten oder Umpolen des elektrischen Feldes umfassen.

27. Vorrichtung nach Anspruch 25, dadurch gekennzeichnet, daß die Mittel eine Ultraschallquelle umfassen.

28. Vorrichtung nach Anspruch 25, dadurch gekennzeichnet, daß die Mittel eine Strömung der Lösung entlang der Oberfläche des Dielektrikums hervorrufen.

29. Vorrichtung nach einem der Ansprüche 1 bis 28, dadurch gekennzeichnet, daß das elektrische Feld eine auf die mit Lösung in Berührung stehende Oberfläche des Dielektrikums senkrechte Feldkomponente aufweist.

30. Verfahren zum Steuern der Keimbildung bzw. des epitaktischen Aufwachsens von Kristallen aus einer Lösung an einer Oberfläche eines Dielektrikums, insbesondere an den funktionellen Gruppen eines Polymers, wobei das Dielektrikum zumindest im Bereich seiner Oberfläche einem einstellbaren elektrischen Feld ausgesetzt wird, dadurch gekennzeichnet, daß im Dielektrikum zwei Elektroden unterschiedlicher Polarität derart angeordnet werden, daß sich zwischen ihnen keine Lösung befindet.

31. Verfahren nach Anspruch 30, dadurch gekennzeichnet, daß das Dielektrikum im feldlosen Zustand unpolare Moleküle aufweist, die im elektrischen Feld polarisiert werden.

32. Verfahren nach Anspruch 30, dadurch gekennzeichnet, daß das Dielektrikum bereits im feldlosen Zustand polare Moleküle aufweist, die im elektrischen Feld ausgerichtet werden.

33. Verfahren nach einem der Ansprüche 30 bis 32, dadurch gekennzeichnet, daß funktionelle Gruppen an der Oberfläche des Dielektrikums von dieser weg in die Lösung hinein ausgerichtet werden.

34. Verfahren zur Herstellung einer Vorrichtung nach einem der Ansprüche 1 bis 29, dadurch gekennzeichnet, daß das Dielektrikum bei der Herstellung während eines Aushärt- oder Erstarrungsprozesses einem elektrischen Feld ausgesetzt wird.

35. Verfahren nach Anspruch 34, dadurch gekennzeichnet, daß leitende Elektroden bei der Herstellung im Dielektrikum miteingeformt, vorzugsweise miteingegossen werden.

36. Verfahren nach Anspruch 35 oder 36, dadurch gekennzeichnet, daß über jene Elekroden, über die später im Betrieb ein elektrisches Feld ein Dielektrikum erzeugbar ist, auch bei der Herstellung ein elektrisches Feld angelegt wird.

## Claims

1. Device for specific formation of seeds or crystals on the surface of a dielectric in contact with a solution, in particular on the functional groups of a polymer, with a means for generating an electric field in the dielectric which comprises an electrically conductive electrode arranged in the dielectric as well as an electrically conductive electrode of a different polarity, wherein the electric field in the dielectric (1) covers the surface adjacent to the solution, characterised in that the electrode (3) of a different polarity is arranged in or on the dielectric (1), wherein no solution is located between the electrode (2) and the associated electrode (3) of a different polarity.

2. Device according to claim 1, characterised in that the electrical field generated by the means can be adjusted using a control means (5), wherein the size of the electrical field in the area of the surface of the dielectric (1) is adjustable.

3. Device according to claim 1 or 2, characterised in that the electrical field is a constant field, wherein preferably the range and/or direction of the field can be controlled.

4. Device according to claim 1 or 2, characterised in that the electrical field is an alternating field, wherein preferably the range, direction and/or the frequency can be controlled.

5. Device according to one of claims 1 to 4, characterised in that polymers, crystals, metal oxides or glasses are used as dielectrics (1).

6. Device according to one of claims 1 to 5, characterised in that a dielectric base material (1) is provided, at least in the surface area, with functional groups such as, for example, carboxylate groups, carbonyl groups or amino groups.

7. Device according to claim 6, characterised in that the functional groups are integrated into a polymer matrix by selection of suitable monomers.

8. Device according to one of claims 1 to 7, characterised in that the surface of the dielectric (1) is - preferably cylindrically - curved.

9. Device according to one of claims 1 to 8, characterised in that the surface of the dielectric (1) forms the internal surface of a tube.

10. Device according to one of claims 1 to 7, characterised in that the surface of the dielectric (1) is substantially planar.

11. Device according to one of claims 1 to 7, characterised in that the surface of the dielectric (1) has the shape of a fish-trap.

12. Device according to one of claims 1 to 11, characterised in that an electrode is a perforated electrode (3), wherein the electric field penetrates through the perforations in the perforated electrode and covers the surface of the dielectric (1).

13. Device according to claim 12, characterised in that in the dielectric (1), substantially planar perforated electrodes (3) are arranged on both sides of a central, substantially planar electrode (2).

14. Device according to one of claims 1 to 13, characterised in that at least some of the electrodes (3) are cylindrically curved.

15. Device according to one of claims 1 to 14, characterised in that metal electrodes, metal lattices, metal foils, electrically conductive plastics and/or graphite are used as electrodes (2, 3).

16. Device according to one of claims 1 to 15, characterised in that at least some of the electrodes (2, 3) are cast into a hardening dielectric.

17. Device according to one claims 1 to 16, characterised in that at least some of the electrodes are vapour deposited as conductive layers or applied as conductivity lacquer or amalgam layers.

18. Device according to one of claims 1 to 17, characterised in that at least some electrodes are produced as electrolyte.

19. Device according to one of claims 1 to 18, characterised in that the electrical field is formed by at least one electret (6).

20. Device according to claim 19, characterised in that the electret (6) is surrounded by a layer supporting preferably active functional groups, in particular a polymer layer (1).

21. Device according to one of claims 1 to 20, characterised in that the electrical field is generated by a pyroelectrical or piezoelectrical effect.

22. Device according to one of claims 1 to 21, characterised in that the dielectric and/or the electrodes generating the electrical field are generated by planar epitaxy.

23. Device according to one of claims 1 to 22, characterised in that the potential of the solution is set at a higher, lower or equal potential defined in comparison with the field-generating electrodes.

24. Device according to one of claims 1 to 23, characterised by means for expanding or compressing the dielectric.

25. Device according to one of claims 1 to 24, characterised by means for removing the seeds or crystals formed on the dielectric.

26. Device according to claim 25, characterised in that the means comprise a control means for switching or reversing the poles of the electrical field.

27. Device according to claim 25, characterised in that the means comprise an ultrasonic source.

28. Device according to claim 25, characterised in that the means cause flow of the solution along the surface of the dielectric.

29. Device according to one of claims 1 to 28, characterised in that the electrical field is provided with a field component perpendicular to the surface of the dielectric in contact with the solution.

30. Method for controlling the seed formation and epitaxial growth of crystals from a solution on a surface of a dielectric, in particular on the functional groups of a polymer, wherein the dielectric is exposed, at least in the area of its surface, to an adjustable electrical field, characterised in that two electrodes of different polarity are arranged in the dielectric such that no solution is located between them.

31. Method according to claim 30, characterised in that in the zero-field state, the dielectric has unpolarised molecules which are aligned in the electric field.

32. Method according to claim 30, characterised in that the dielectric has polarised molecules even in the zero-field state, which are aligned in the electrical field.

33. Method according to one of claims 30 to 32, characterised in that functional groups on the surface of the dielectric are aligned in the solution in this manner.

34. Method for manufacturing a device according to one of claims 1 to 29, characterised in that during manufacturing, the dielectric is exposed to an electrical field during a hardening or solidifying process.

35. Method according to claim 34, characterised in that conductive electrodes are moulded into the dielectric during manufacturing, preferably cast therein.

36. Method according to claim 35 or 36, characterised in that an electrical field is applied, also during manufacturing, to those electrodes by means of which an electrical field can be generated in a dielectric in later operation.

## Revendications

1. Dispositif pour la formation ciblée de germes ou cristaux à la surface d'un diélectrique en contact avec une solution, en particulier sur les groupes fonctionnels d'un polymère avec un système pour générer un champ électrique dans le diélectrique, ledit système comprenant une électrode électriquement conductrice disposée dans le diélectrique ainsi qu'une électrode électriquement conductrice d'une polarité différente, le champ électrique dans le diélectrique (1) atteignant la surface tournée vers la solution, caractérisé en ce que l'électrode (3) de polarité différente est disposée à l'intérieur ou sur le diélectrique (1), aucune solution ne se trouvant entre l'électrode (2) et l'électrode (3) associée de polarité différente.

2. Dispositif selon la revendication 1, caractérisé en ce que le champ électrique généré par le système est réglable au moyen d'un dispositif de commande (5), l'ampleur du champ électrique étant réglable dans la zone de la surface du diélectrique (1).

3. Dispositif selon la revendication 1 ou 2, caractérisé en ce que le champ électrique est un champ continu où de préférence la valeur et/ou la direction du champ peuvent être commandées.

4. Dispositif selon la revendication 1 ou 2, caractérisé en ce que le champ électrique est un champ alternatif où de préférence la valeur, la direction et/ou la fréquence peuvent être commandées.

5. Dispositif selon l'une des revendications 1 à 4, caractérisé en ce qu'on utilise en tant que diélectriques (1) des polymères, des cristaux, des céramiques, des oxydes de métaux ou des verres.

6. Dispositif selon l'une des revendications 1 à 5, caractérisé en ce qu'une matière diélectrique de base (1) présente, au moins dans la zone de surface, des groupes fonctionnels, tels que des groupes carboxylates, des groupes carbonyles ou des groupes aminos.

7. Dispositif selon la revendication 6, caractérisé en ce que les groupes fonctionnels sont incorporés à une matrice polymère par sélection de monomères appropriés.

8. Dispositif selon l'une des revendications 1 à 7, caractérisé en ce que la surface du diélectrique (1) est courbée, de préférence cylindrique.

9. Dispositif selon l'une des revendications 1 à 8, caractérisé en ce que la surface du diélectrique (1) constitue la surface interne d'un tube.

10. Dispositif selon l'une des revendications 1 à 7, caractérisé en ce que la surface du diélectrique (1) est sensiblement plane.

11. Dispositif selon l'une des revendications 1 à 7, caractérisé en ce que la surface du diélectrique (1) a une forme de pyramide.

12. Dispositif selon l'une des revendications 1 à 11, caractérisé en ce qu'une électrode est une électrode percée (3), le champ électrique traversant les trous de l'électrode percée (3) et atteint la surface du diélectrique (1).

13. Dispositif selon la revendication 12, caractérisé en ce que dans le diélectrique (1), des électrodes percées sensiblement planes (3) sont disposées de part et d'autre d'une électrode centrale sensiblement plane (2).

14. Dispositif selon l'une des revendications 1 à 13, caractérisé en ce que les électrodes (3) sont courbées au moins de manière partiellement cylindrique.

15. Dispositif selon l'une des revendications 1 à 14, caractérisé en ce qu'en tant qu'électrodes (2, 3), on utilise des électrodes métalliques, des grilles métalliques, des feuilles métalliques, des matières synthétiques électriquement conductrices et/ou du graphite.

16. Dispositif selon l'une des revendications 1 à 15, caractérisé en ce que les électrodes sont au moins partiellement pris en coulage dans un diélectrique durcissant.

17. Dispositif selon l'une des revendications 1 à 16, caractérisé en ce les électrodes sont au moins partiellement déposées par évaporation ou appliquées sous forme de couches d'amalgame ou de vernis conductible.

18. Dispositif selon l'une des revendications 1 à 17, caractérisé en ce que les électrodes sont réalisées au moins partiellement sous forme d'électrolyte.

19. Dispositif selon l'une des revendications 1 à 18, caractérisé en ce que le champ électrique est au moins formé par un électrète (6).

20. Dispositif selon la revendication 19, caractérisé en ce que l'électrète (6) est entouré d'une couche de préférence active portant des groupes fonctionnels, en particulier une couche de polymère (1).

21. Dispositif selon l'une des revendications 1 à 20, caractérisé en ce que le champ électrique est généré par un effet pyro-électrique ou piézo-électrique.

22. Dispositif selon l'une des revendications 1 à 21, caractérisé en ce que le diélectrique et/ou les électrodes générant le champ électrique sont produits par une technique épitaxiale planaire.

23. Dispositif selon l'une des revendications 1 à 22, caractérisé en ce que le potentiel de la solution est amené à un potentiel identique, inférieur ou supérieur qui est défini par rapport aux électrodes génératrices de champ.

24. Dispositif selon l'une des revendications 1 à 23, caractérisé par des moyens d'extension et de compression du diélectrique.

25. Dispositif selon l'une des revendications 1 à 24, caractérisé par des moyens de dissolution des germes ou cristaux formés sur le diélectrique.

26. Dispositif selon la revendication 25, caractérisé en ce que les moyens comprennent un dispositif de commande pour la neutralisation ou le changement de polarité du champ électrique.

27. Dispositif selon la revendication 25, caractérisé en ce que les moyens comportent une source à ultrasons.

28. Dispositif selon la revendication 25, caractérisé en ce que les moyens provoquent un écoulement de la solution le long de la surface du diélectrique.

29. Dispositif selon l'une des revendications 1 à 28, caractérisé en ce que le champ électrique présente une composante de champ perpendiculaire sur la surface du diélectrique en contact avec la solution.

30. Procédé pour la commande de la formation de germes et de la croissance épitaxiale de cristaux à partir d'une solution à la surface d'un diélectrique, en particulier sur les groupes fonctionnels d'un polymère, le diélectrique étant exposé au moins dans la zone de sa surface à un champ électrique réglable, caractérisé en ce que dans le diélectrique, deux électrodes de polarité différente sont disposées de manière à exclure entre elles la présence d'une solution.

31. Procédé selon la revendication 30, caractérisé en ce que le diélectrique présente, en l'absence de champ, des molécules non polaires qui sont polarisées dans le champ électrique.

32. Procédé selon la revendication 30, caractérisé en ce que le diélectrique présente déjà en l'absence de champ des molécules polaires qui sont orientées dans le champ électrique.

33. Dispositif selon l'une des revendications 30 à 32, caractérisé en ce que des groupes fonctionnels sont orientés à la surface du diélectrique de manière à s'éloigner de ce dernier pour pénétrer dans la solution.

34. Procédé pour la fabrication d'un dispositif selon l'une des revendications 1 à 29, caractérisé en ce qu'au moment de la fabrication, le diélectrique est exposé à un champ électrique au cours d'un processus de durcissement ou de solidification.

35. Procédé selon la revendication 34, caractérisé en ce que des électrodes conductrices sont moulées ensemble, de préférence prises ensemble au coulage dans le diélectrique lors de la fabrication.

36. Procédé selon la revendication 34 ou 35, caractérisé en ce qu'un champ électrique est également appliqué pendant la fabrication, par les électrodes, par l'intermédiaire desquelles un champ électrique peut être généré ultérieurement, en cours de fonctionnement dans un diélectrique.
